# EUROPEAN PATENT APPLICATION

(11) **EP 3 492 211 A1**
(43) Date of publication of application: **05.06.2019**
(21) Application number: 17834394.3
(22) Date of filing: 26.07.2017
(51) Int. Cl.: B23K 26/354, C23C 26/00, H05K 3/00, H05K 3/38

(54) **LASER TREATMENT METHOD, BONDING METHOD, COPPER MEMBER, METHOD FOR MANUFACTURING MULTILAYER PRINT WIRING SUBSTRATE, AND MULTILAYER PRINT WIRING SUBSTRATE**

(30) Priority: 27.07.2016 JP 2016147575
(71) Applicant: Furukawa Electric Co. Ltd., Tokyo 100-8322 (JP)
(72) Inventor: IWAMA, Masaki, Tokyo 100-8322 (JP); MATSUSHITA, Shunichi, Tokyo 100-8322 (JP)
(74) Representative: Zacco GmbH
(86) International application number: PCT/JP2017/026996
(87) International publication number: WO 2018/021392

(57) **Abstract**

The present invention is a laser processing method of performing surface processing on a copper surface by using laser. The method forms a periodic structure (12) on the order of laser wavelength on a copper surface (11) by irradiating the copper surface (11) with pulse laser (2) having a laser power close to a threshold beyond which processing of copper foil (10) is possible and having a pulse width on the order of nanoseconds, and forms a coating (13) on the copper surface (11). In this manner, the copper surface can be processed to have a favorable electric characteristic and desirable adhesion with a resin material.

## Description

### Technical Field

The present invention relates to a laser processing method of processing a copper surface by using laser, a joint method of joining copper foil to a resin material, and a copper member provided with surface processing.

### Background Art

In the progress of diversification and high functionalities of materials along with rapid development of industries such as electronics and automobile, demand for members obtained by efficiently combining dissimilar materials of resin and metal, in particular, has been increasing for reduction of component weight, improvement of designing freedom, cost reduction, and the like.

Typically, it is difficult to improve adhesion at a joint of a member obtained by combining dissimilar materials. For example, in a semiconductor package structure in which a substrate is molded by resin, particularly at high temperature, problems such as resin crack and chip flake occur due to insufficient adhesion between resin and metal, difference in thermal expansion rate between resin and a lead frame (metal), and expansion of water in the package.

To solve the problems as described above, Patent Literatures 1 to 3 disclose technologies of roughing the surface of a metal member to form irregularity at a joint with a dissimilar material, in particular, thereby increasing adhesion at the joint.

### Document List

### Patent Literature(s)

Patent Literature 1: Japanese Patent Application Laid-Open No. 1998-294024
Patent Literature 2: Japanese Patent Application Laid-Open No. 2010-167475
Patent Literature 3: Japanese Patent Application Laid-Open No. 2013-111881

### Summary of Invention

### Technical Problem

As described above, in the inventions according to Patent Literatures 1 to 3, the surface of a metal member is roughed to form irregularity at a joint with a dissimilar material. When a high-frequency signal is transmitted through copper foil, finer irregularity is desired to be formed on the copper surface to increase adhesion with a resin material while reducing a transmission loss due to the skin effect.

However, it is difficult to apply the inventions according to Patent Literatures 1 to 3 to form fine irregularity on the surface of metal such as copper having significantly high thermal conductivity and low light absorptivity. Specifically, it needs to use ultrashort pulse laser of picoseconds or femtoseconds to form fine irregularity on the surface, but such ultrashort pulse laser has low processing efficiency due to the short duration of mutual interaction between light and metal, and laser itself is also expensive.

In view of the the above-described problem, an object of the present invention is to provide a laser processing method capable of processing a copper surface to have a favorable electric characteristic and desirable adhesion with a resin material, a joint method of joining copper foil to a resin material, a copper member provided with surface processing, a method of manufacturing a multi-layer printed circuit board, and a multi-layer printed circuit board.

### Solution to Problem

A laser processing method according to one aspect of the present invention is a laser processing method of performing surface processing on a copper surface by using laser. The method is characterized by forming a periodic structure on the order of laser wavelength on the copper surface by irradiating the copper surface with pulse laser having a laser power close to a threshold beyond which copper processing is possible and having a pulse width on the order of nanoseconds. Specifically, the method manages the pulse width on the order of nanoseconds in a high fluence region, which has not been conventionally discussed, and forms a periodic structure on the order of laser wavelength on the copper surface. The fluence is a value obtained by dividing the peak power of the pulse laser by the beam area.

With the above-described configuration, a periodic structure on the order of laser wavelength can be formed on a copper surface by irradiating the copper surface with pulse laser having a laser power close to a threshold beyond which copper processing is possible and having a pulse width on the order of nanoseconds. With such a periodic structure on the order of laser wavelength, a high-frequency signal can be transmitted at low loss, and the periodic structure functions as an anchor when joined with another member to have favorable adhesion with the member. In addition, when laser on the order of nanoseconds is used, fast and inexpensively processing can be achieved as compared to, for example, a case of using ultrashort pulse laser of picoseconds or femtoseconds.

The laser processing method according to a preferable aspect of the present invention is characterized by forming a coating on the copper surface together with forming the periodic structure on the order of laser wavelength on the copper surface.

The laser processing method according to a preferable aspect of the present invention is characterized by forming a dendrite structure having a period shorter than a period of the periodic structure on the order of laser wavelength by accumulating or depositing copper at a protruding part of the periodic structure on the order of laser wavelength.

The laser processing method according to a preferable aspect of the present invention is characterized in that the copper surface is irradiated with pulse laser having a wavelength of 1000 nm to 1600 nm, a pulse width of 0.8 ns to 5.0 ns, and a fluence of 1.0×10⁸ W/cm² to 4.0×10⁹ W/cm² under air or atmosphere of oxygen, water, or active gas.

The laser processing method according to a preferable aspect of the present invention is characterized in that the periodic structure is formed in a predetermined direction on the copper surface by irradiating the copper surface with the pulse laser while controlling the polarization direction of the pulse laser. According to the present aspect, anisotropic adhesion control to obtain strong adhesion in the predetermined direction and weak adhesion in a direction orthogonal to the predetermined direction can be achieved.

The laser processing method according to a preferable aspect of the present invention is characterized in that the copper surface is irradiated with the pulse laser having an energy profile set in a top hat shape.

The laser processing method according to a preferable aspect of the present invention is characterized in that an identical irradiation position on the copper surface is irradiated with the pulse laser while the fluence of the pulse laser is gradually reduced.

A joint method according to one aspect of the present invention is a joint method of joining copper foil to a resin material. The method is characterized by forming a roughed part having a periodic structure on the order of laser wavelength on a surface of the copper foil by irradiating the surface of the copper foil with pulse laser having a laser power close to a threshold beyond which copper processing is possible and having a pulse width on the order of nanoseconds, and performs laser welding or heat press bonding of the roughed part formed on the surface of the copper foil to the resin material.

In a copper member according to one aspect of the present invention, a periodic structure having a period of 0.35 µm to 2 µm in a planar direction and a height of less than 1.5 µm is formed on at least one surface.

The copper member according to a preferable aspect of the present invention is characterized in that the ratio of the height of the periodic structure relative to the thickness of the copper member is 0.15% to 30% inclusive.

The copper member according to a preferable aspect of the present invention is characterized in that a coating is formed on the periodic structure, and an irregular structure having a period shorter than a period of the periodic structure is formed on a surface of the coating.

The copper member according to a preferable aspect of the present invention is characterized in that the surface area of the coating on which the irregular structure is formed is at least ten times larger than the surface area of the surface on which the periodic structure is formed.

The copper member according to a preferable aspect of the present invention is characterized in that the irregular structure is made of a dendrite structure.

The copper member according to a preferable aspect of the present invention is characterized in that the copper member is copper foil.

A method of manufacturing a printed circuit board according to one aspect of the present invention is a printed circuit board manufacturing method of manufacturing a multi-layer printed circuit board. The method is characterized by forming a periodic structure on the order of laser wavelength at the inner-layer wiring part by selectively irradiating an inner-layer wiring part of the multi-layer printed circuit board with pulse laser having a laser power close to a threshold beyond which copper processing is possible and having a pulse width on the order of nanoseconds.

The method of manufacturing a printed circuit board according to a preferable aspect of the present invention provides a multi-layer printed circuit board on which an inner-layer wiring part is formed, characterized in that a periodic structure having a period of 0.35 µm to 2 µm in a planar direction and a height of less than 1.5 µm is formed in parallel to a current conduction direction at the inner-layer wiring part.

### Effects of Invention

The present invention can provide a laser processing method capable of processing a copper surface to have a favorable electric characteristic and desirable adhesion with a resin material, a joint method of joining copper foil to a resin material, a copper member provided with surface processing, a method of manufacturing a multi-layer printed circuit board, and a multi-layer printed circuit board.

### Brief Description of Drawings

[Fig. 1] A diagram schematically illustrating a laser processing process of performing surface processing on a copper surface by using laser.
[Fig. 2] A diagram illustrating evaluation of surface processing in which laser processing is performed under a plurality of kinds of conditions into four items of "processing", "mixed processing and coating removal", "coating removal", and "blackening" where the horizontal axis represents the pulse width [ns] and the vertical axis represents the fluence [W/cm²].
[Fig. 3] A diagram illustrating an image of a copper surface 11 provided with surface processing through the laser processing process, which is obtained through magnification of 2000 times by an electron microscope.
[Fig. 4] Fig. 4(A) is an image of a sectional structure of copper foil 10 provided with surface processing by using pulse laser, which is obtained through magnification of 10000 times by an electron microscope; and Fig. 4(B) is an image of a sectional structure of the copper foil 10 provided with surface processing by using pulse laser, which is obtained through magnification of 50000 times by an electron microscope.
[Fig. 5] A diagram illustrating a result of analysis of the copper surface 11 of the copper foil 10 after laser processing by X-ray photoelectron spectroscopy.
[Fig. 6] Fig. 6(A) is a diagram illustrating a sectional structure of a composite material 61 as a comparative example obtained by performing laser welding or heat press bonding of a surface 611 of copper foil 610 not provided with laser processing to a resin material 620; and Fig. 6(B) is a diagram illustrating a sectional structure of a composite material 100 obtained by performing laser welding or heat press bonding of the copper surface 11 of the copper foil 10 provided with laser processing to a resin material 20.
[Fig. 7] A diagram for description of the method of performing a peeling test.

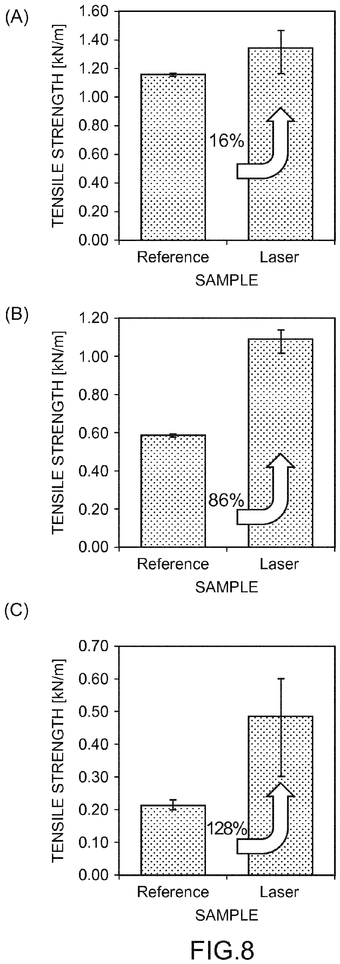

[Fig. 8] Fig. 8(A) is a diagram illustrating peel strength obtained by preparing two kinds of composite materials each produced by bonding the M surface of copper foil to a resin substrate made of FR4 with or without laser processing, and performing the peeling test on each composite material; Fig. 8(B) is a diagram illustrating peel strength obtained by preparing two kinds of composite materials each produced by bonding the S surface of copper foil to a resin substrate made of FR4 with or without laser processing, and performing the peeling test on each composite material; and Fig. 8(C) is a diagram illustrating peel strength obtained by preparing two kinds of composite materials each produced by bonding the S surface of copper foil to a resin substrate made of Megtron6 with or without laser processing, and performing the peeling test on each composite material.
[Fig. 9] A diagram schematically illustrating the copper foil 10 on which a periodic structure 12 is formed by the laser processing process according to the present embodiment.
[Fig. 10] A diagram for description of the method of calculating the surface area of a coating 450.

### Description of Embodiments

The following describes an embodiment for achieving the present invention (hereinafter referred to as the present embodiment) with specific examples. The present embodiment relates to a laser processing method of performing surface processing on a copper surface by using laser.

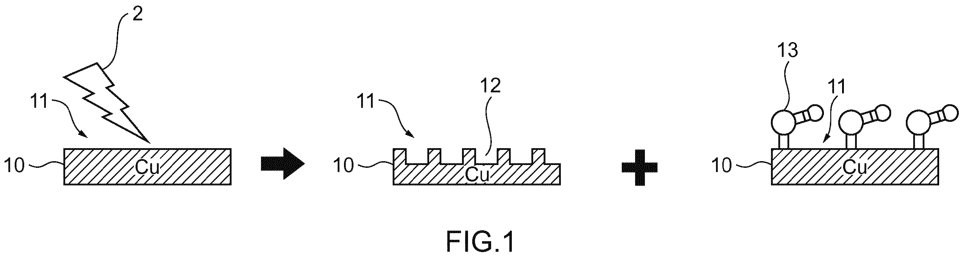

Fig. 1 is a diagram schematically illustrating a laser processing process of performing surface processing on a copper surface by using laser. In the laser processing process according to the present embodiment, a copper surface 11 of a copper member 10 is irradiated with pulse laser having a pulse width managed on the order of nanoseconds in a high fluence region, which has not been conventionally discussed. Specifically, as illustrated in Fig. 1, the copper surface 11 of the copper member 10 is irradiated with pulse laser 2 having a laser power close to a threshold beyond which copper processing is possible and having a pulse width on the order of nanoseconds. The order of nanoseconds indicates, for example, the range of 0.8 ns to 5.0 ns. The fluence is a value obtained by dividing the peak power of the pulse laser by the beam area.

The copper member 10 is made of a metallic material containing copper (Cu) as a primary component, and is, for example, a copper plate. In the present embodiment, such a copper plate having a thickness of 500 µm or lessis referred to as copper foil. In the present embodiment, as an example, the copper member 10 is copper foil, and referred to as "copper foil 10" below.

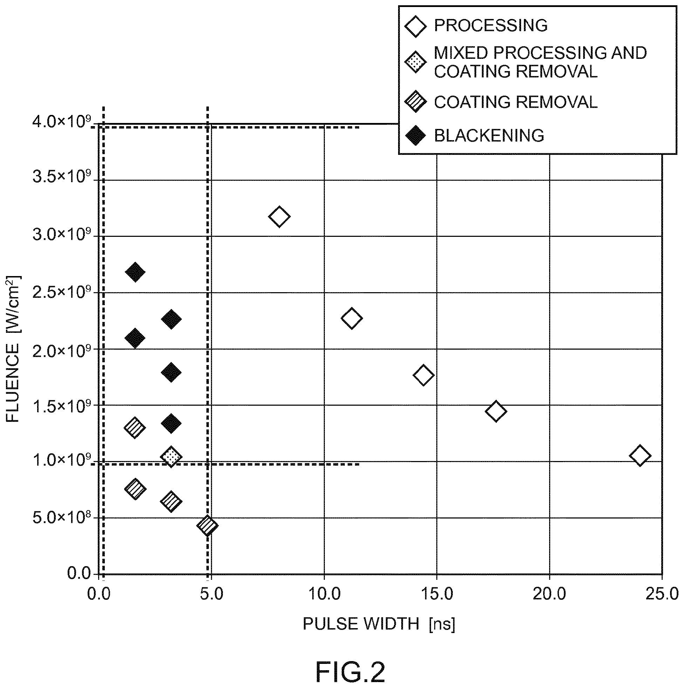

The following describes characteristics of a copper foil surface processed by laser having different values of the fluence [W/cm²] and the pulse width [ns] as laser power. Fig. 2 is a diagram illustrating evaluation of surface processing in which laser processing is performed under a plurality of kinds of conditions into four items of "processing", "mixed processing and coating removal", "coating removal", and "blackening" where the horizontal axis represents the pulse width [ns] and the vertical axis represents fluence [W/cm²].

The "processing" refers to a processing in which copper is removed through melting and evaporation due to ablation or heat input to form a groove in a size equivalent to the diameter of a processing beam, the "coating removal" refers to processing in which only a copper compound coating such as rust on the copper foil surface is removed, the "mixed processing and coating removal" refers to processing in which the processing and the coating removal are simultaneously performed, and the "blackening" refers to processing in a middle region between the "processing" and the "coating removal", in which a coating of oxide or the like on the copper foil surface and a fine periodic structure on the order of laser wavelength are simultaneously formed. The beam diameter refers to the spot size of a Gaussian beam. When the processing is performed with the Gaussian beam, a copper surface layer is removed at a central part of the beam, at which the fluence is high, in the blackening in some cases. Thus, it is more preferable that the processing beam has an energy profile in a top hat shape than a Gaussian shape. Accordingly, it is preferable to set the energy profile of the pulse laser in a top hat shape.

The evaluation illustrated in Fig. 2 indicates it is preferable to perform processing at a fluence and a pulse width between the "processing" and the "coating removal". Specifically, a laser processing condition of a pulse width (first pulse width) and a fluence (first fluence) with which formation of a groove in a size equivalent to the processing beam diameter on the copper surface 11 is possible, and a laser processing condition of a pulse width (second pulse) and a fluence (second fluence) that have values smaller than the values of the first pulse width and the first fluence, respectively and with which removal of only a copper compound coating from the copper surface 11 is possible are acquired and stored as profile data in advance in, for example, a storage provided to a laser processing apparatus. Then, the laser processing apparatus forms a periodic structure on the order of laser wavelength by referring to the profile data and irradiating the copper surface 11 with pulse laser having a pulse width set to be between the first pulse width and the second pulse width and a fluence set to be between the first fluence and the second fluence. When pulse laser set to have a pulse width of 0.8 ns to 5.0 ns and a fluence of 1.0×10⁸ W/cm² to 4.0×10⁹ W/cm², which are specific numerical values obtained from the result illustrated in Fig. 2, is used, pulse energy is close to a processing threshold of the copper foil, and a periodic structure 12 and a coating 13 can be formed on the copper surface 11 of the copper foil 10 as illustrated in Fig. 1.

In particular, it is preferable that such pulse laser having a laser power close to a threshold beyond which copper processing is possible and having a pulse width on the order of nanoseconds satisfy conditions as follows.

The pulse width on the order of nanoseconds has a range of 0.8 ns to 999 ns.

Specifically, it is preferable to irradiate the copper surface 11 with pulse laser having a wavelength of 1000 nm to 1600 nm, a pulse width of 0.8 ns to 999 ns, and a fluence of 1.0×10⁸ W/cm² to 4.0×10⁹ W/cm² in air under atmosphere of oxygen, water, or active gas.

It is more preferable that the copper surface 11 be irradiated with pulse laser having a wavelength of 1000 nm to 1600 nm, a pulse width of 0.8 ns to 5.0 ns, and a fluence of 1.0×10⁸ W/cm² to 4.0×10⁹ W/cm² under air or atmosphere of oxygen, water, or active gas.

It is still more preferable that the copper surface 11 be irradiated with pulse laser having a wavelength of 1000 nm to 1600 nm, a pulse width of 1.0 ns to 5.0 ns, and a fluence of 1.0×10⁸ W/cm² to 4.0×10⁹ W/cm² under air or atmosphere of oxygen, water, or active gas.

Copper causes improvement of light absorptivity and decrease of thermal conductivity when an oxide coating is formed on the surface thereof, and laser processing is promoted accordingly. Thus, it is preferable that, when an identical place is processed by laser several times, the processing be performed while the fluence is gradually reduced.

The periodic structure is formed orthogonal to the polarization direction of a processing beam. Thus, a structure having periodicity in an optional direction (predetermined direction) can be formed by irradiating the copper surface 11 with pulse laser while controlling the polarization direction of the pulse laser through a wave plate or the like. Anisotropic adhesion control to obtain strong adhesion in the predetermined direction and weak adhesion in a direction orthogonal to the predetermined direction can be achieved by forming the periodic structure in the predetermined direction in this manner.

The periodic structure 12 and the coating 13 on the order of wavelength can be formed on the copper surface 11 of the copper foil 10 by appropriately controlling the fluence so that the laser power becomes close to the threshold beyond which copper processing is possible as described above. The order of wavelength has, for example, a range of 1000 nm to 1600 nm. A periodic structure of 1000 nm or less may be formed by shortening the laser wavelength.

In particular, it is preferable to repeatedly irradiate the copper surface 11 with pulse laser having at least one of parameters of frequency, laser intensity, scanning speed, spot size, wavelength, and atmosphere adjusted in accordance with the height and shape of the periodic structure 12 to be formed on the copper surface 11.

As described above, the laser processing process according to the present embodiment forms the periodic structure 12 on the order of the laser wavelength by irradiating the copper surface 11 with pulse laser having a pulse width managed on the order of nanoseconds in a high fluence region, which has not been conventionally discussed. Specifically, the periodic structure 12 on the order of the laser wavelength can be formed on the copper surface 11 by irradiating the copper surface 11 with pulse laser having a laser power close to the threshold beyond which copper processing is possible and having a pulse width on the order of nanoseconds. In addition, when laser on the order of nanoseconds is used, fast and inexpensively processing can be achieved as compared to, for example, a case of using ultrashort pulse laser of picoseconds or femtoseconds.

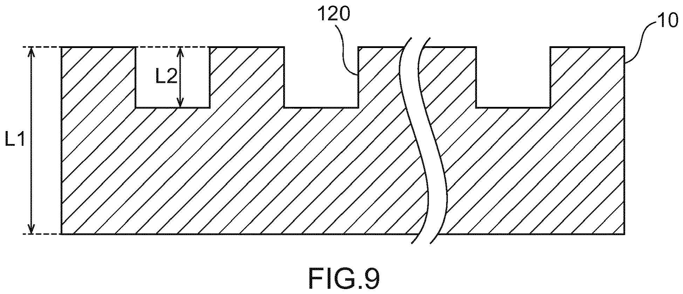

Fig. 9 is a diagram schematically illustrating the copper foil 10 on which the periodic structure 12 is formed through the laser processing process according to the present embodiment.

As illustrated in Fig. 9, when L1 represents the thickness of the copper foil 10, in other words, the distance between the copper surface 11 and a back surface 14 facing to the copper surface 11, and L2 represents the height of the periodic structure 12, in other words, the distance between the copper surface 11 and the bottom surface of a recessed part (groove) 120 forming the periodic structure 12, the ratio of the height L2 of the periodic structure 12 relative to the thickness L1 of the copper foil 10 is 0.15% to 30% inclusive.

The following describes the periodic structure 12 and the coating 13 in detail.

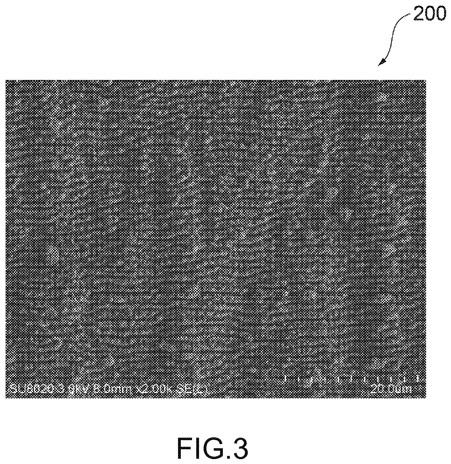

Fig. 3 illustrates an image of the copper surface 11 provided with surface processing through the above-described laser processing process, which is obtained through magnification of 2000 times by an electron microscope. As understood from Fig. 3, an uniform periodic structure 200 of 1200 nm approximately is formed on the surface of the copper foil.

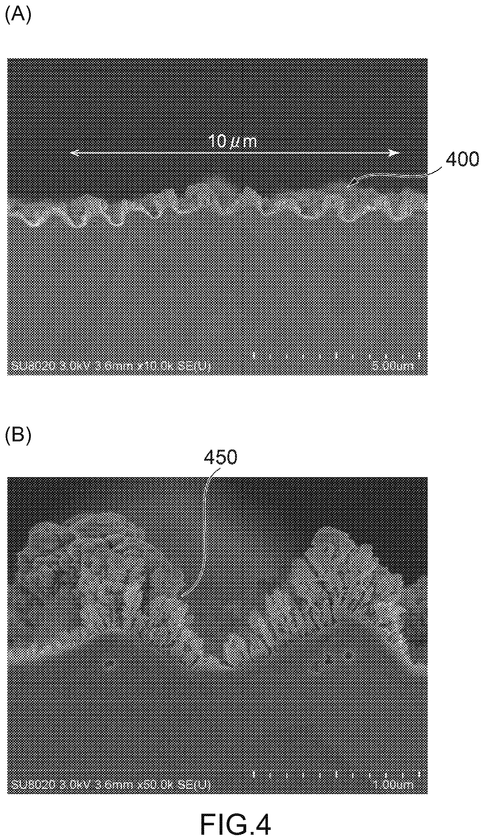

Fig. 4 is an image illustrating a sectional structure of the copper foil 10 provided with surface processing by using pulse laser. Specifically, Fig. 4(A) is an image obtained through magnification at 10000 times by an electron microscope, and Fig. 4(B) is an image obtained through magnification at 50000 times by an electron microscope. As understood from Fig. 4(A), a periodic structure 400 having a height of 400 nm approximately is formed in about eight periods per 10000 nm (10 µm), in other words, in the period of 1250 nm. As illustrated in Fig. 4(B) in an enlarged view of the periodic structure 400, a coating 450 in a dendrite structure as an irregular structure having a shorter period and a height of 400 nm approximately is formed on the periodic structure 400.

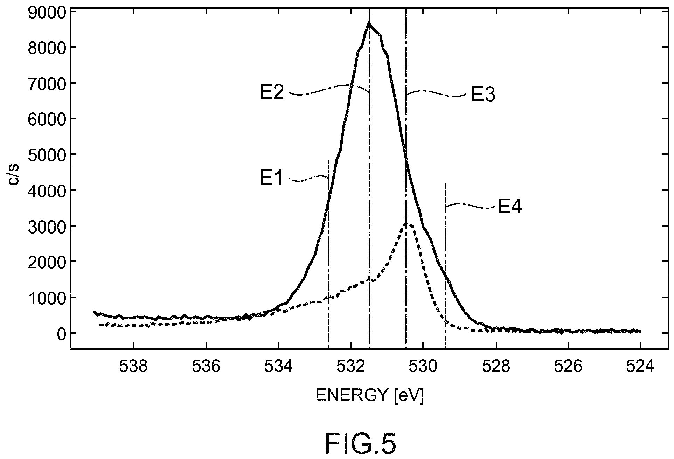

Fig. 5 illustrates a result of analysis of the copper surface 11 of the copper foil 10 after the laser processing by X-ray photoelectron spectroscopy. Specifically, Fig. 5 illustrates a result of analysis of the copper foil after the laser processing with a solid line, and illustrates, as a comparative example, a result of analysis of the copper foil before the laser processing with a dashed line. In Fig. 5, binding energy E1 corresponds to a measured value of organic C-O bond, binding energy E2 corresponds to a measured value of organic C=O bond of Cu hydroxide, binding energy E3 corresponds to a measured value of Cu₂O, and binding energy E4 corresponds to a measured value of CuO. Increase of Cu hydroxide and CuO in the copper foil after the laser processing as compared to the unprocessed copper foil is observed in a result of comparison between the solid line and the dashed line in Fig. 5, which clearly indicates that an oxide coating is formed on the copper surface.

For example, when the copper foil is used for usage on a printed circuit board or the like and it is not preferable that the oxide coating 450 remain, the oxide coating 450 can be removed through cleaning with dilute sulfuric acid. In such a case, too, the periodic structure 400 may remain.

As understood from Fig. 3 to Fig. 5 described above, the periodic structure 12 (1200 nm approximately) and the coating 13 on the order of wavelength are formed on the copper surface 11 of the copper foil 10. With the periodic structure 12 and the coating 13, a high-frequency signal can be transmitted at low loss, and the periodic structure 12 and the coating 13 function as an anchor when joined with another member to have favorable adhesion with the member for the following reason.

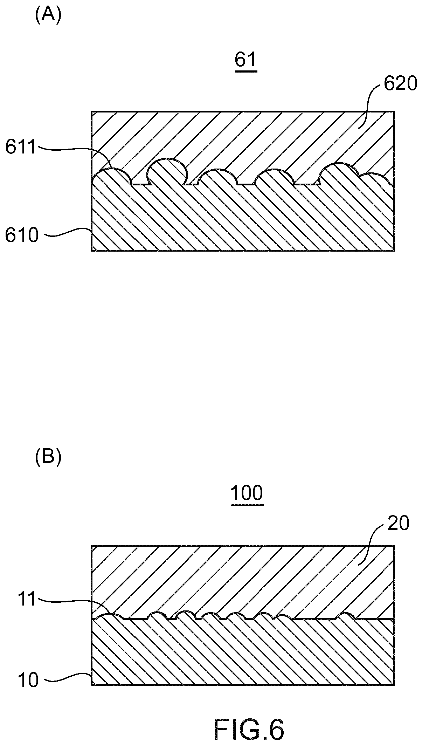

Fig. 6(A) is a diagram illustrating a sectional structure of a composite material 61 obtained by performing laser welding or heat press bonding of a surface 611 of copper foil 610 not provided with laser processing to a resin material 620 as a comparative example. The surface 611 of the copper foil 610 according to the comparative example as illustrated in Fig. 6(A) has a shape more irregular in the height (thickness) direction than that of the copper surface 11 of the copper foil 10 according to the present embodiment described above due to, for example, a manufacturing process. Thus, when a high-frequency signal is caused to flow through the copper foil 610, the signal flows up and down along the irregularity of the surface 611 due to the skin effect, which leads to an increased resistance.

Fig. 6(B) is a diagram illustrating a sectional structure of a composite material 100 obtained by performing laser welding or heat press bonding of the copper surface 11 of the copper foil 10 provided with laser processing to a resin material 20. As illustrated in the cross-sectional view in Fig. 6(B), the irregularity of the copper surface 11 of the copper foil 10 in the height (thickness) direction is smaller than that of the surface 611 of the copper foil 610 according to the comparative example due to the periodic structure and the coating described above. Thus, when a high-frequency signal is caused to flow through the copper foil 10, the signal flows up and down along the irregularity of the copper surface 11 due to the skin effect, but the height of the irregularity is smaller than that of the surface 611 described above, which leads to a decreased resistance.

In addition, the periodic structure formed on the copper surface 11 exerts an anchor effect, thereby improving adhesion to the resin material 20. The oxide coating formed on the copper surface 11 promotes formation of chemical bond to the resin material 20, and contributes improvement of chemical adhesion between the copper foil 10 and the resin material 20.

In particular, the copper foil 10 is preferable because a periodic structure having a period of 0.35 µm to 2 µm in a planar direction and a height of less than 1.5 µm is formed on the copper surface 11 so that the resistance can be reduced particularly when a high-frequency signal of 1 GHz band or higher is transmitted. As a specific reason, when the frequency of an electric signal is 1 GHz or higher, the influence of the skin effect that current flows only through the surface of a conductor is significant so that the influence of increase of a conductor loss caused by change of a current transmission path due to the irregularity of the surface cannot be ignored.

It is possible to reliably improve adhesion between the copper foil 10 and the resin material 20 by setting the surface area of the surface of the coating 13, on which an irregular structure is formed, to be at least 10 times larger than the surface area of the copper surface 11, on which the periodic structure 12 is formed.

The following describes numerical examples of the surface area of the copper surface 11 on which the periodic structure 12 is formed and the surface area of the coating 13 (coating 450) on which a dendrite structure 450A is formed.

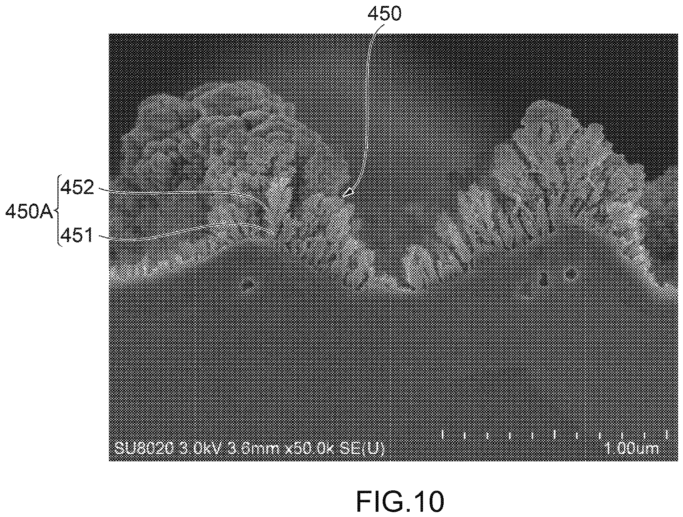

Fig. 10 is a diagram for description of a method of calculating the surface area of the coating 450.

As illustrated in Fig. 10, the dendrite structure 450A included in the irregular structure of the coating 450 is dendritically formed. Thus, the dendrite structure 450A is divided into a primary structure 451 formed on the copper surface 11, and a secondary structure 452 formed as a branch from the primary structure 451, and the surface area of the coating 13 is considered.

Assume that the average height of the primary structure 451 is 0.25 µm, and the average diameter of the primary structure 451 is 0.06 µm. When 15 primary structures 451 are formed per 1µm on the copper surface 11, 225 (= 15x15) primary structures 451 are formed per 1µm² on the copper surface 11. A large number of primary structures 451 are mainly formed at, among a protruding part 121 and a recessed part 120 included in the periodic structure 12, the protruding part 121 as illustrated in Fig. 10. Accordingly, when the protruding part 121 and the recessed part 120 have an area ratio of 3:1, the number of primary structures 451 formed at the protruding part 121 is 168. Thus, the number of primary structures 451 formed per 1µm² on the copper surface 11 is set to be 160.

Assume that the average height of the secondary structure 452 is 0.012 µm, and the average diameter of the secondary structure 452 is 0.025 µm so that 50 secondary structures 452 are formed for each primary structure 451.

In this case, the surface area of the primary structure 451 can be estimated to be 7.992 µm² for each 1 µm² of the surface area of the copper surface 11 with the upper and side areas of the primary structure 451 taken into account. The surface area of the secondary structure 452 can be estimated to be 7.540 µm² for each 1 µm² of the surface area of the copper surface 11 with the side area of the secondary structure 452 taken into account. Thus, the surface area of the coating 450 on which the dendrite structure 450A is formed can be estimated to be 15.53 (= 7.992 + 7.540) µm².

When the area improvement rate of the copper surface 11 due to formation of the periodic structure 12 is 20%, the surface area of the copper surface 11 increases to 1.2 µm² for each 1 µm².

Accordingly, in the case illustrated in Fig. 10, the surface area of the surface of the coating 450 is about 12.94 (= 15.53/1.2) times larger than the surface area of the copper surface 11.

In this manner, when the surface area of the surface of the coating 13 on which the dendrite structure 450A as an irregular structure is formed is set to be at least 10 times larger than the surface area of the copper surface 11, the area of adhesion with the resin material 20 can be reliably increased as compared to a case in which the resin material 20 is directly adhered to the copper surface 11, thereby reliably improving adhesion between the copper foil 10 and the resin material 20.

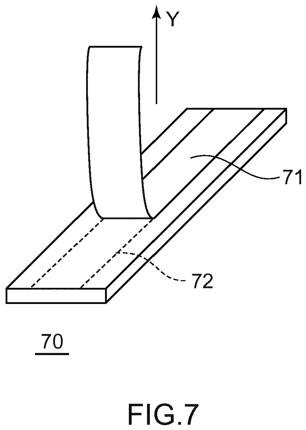

Subsequently, as a peeling test to evaluate adhesion performance of copper foil having a surface provided with laser processing and copper foil having a surface not provided with laser processing, force (tensile strength) necessary for peeling off the copper foil 71 in the direction of arrow Y was measured for a joint material 70 obtained by joining copper foil 71 to a resin material 72 as illustrated in Fig. 7.

Specifically, in a first peeling test, two kinds of composite materials each produced by bonding the M surface of the copper foil to a resin substrate made of FR4 R-1766, which is manufactured by Panasonic Corporation, with or without laser processing were prepared. The copper foil was joined to R-1766, which is manufactured by Panasonic Corporation, at a curing temperature of 170°C for a curing time of one hour.

Then, the tensile strength (peel strength) when these prepared composite materials were each cut and peeled off was measured. Specifically, the resin side of each produced measurement sample was fixed by a support clasp, and the copper foil was peeled off in the direction at 90° to the measurement sample at the speed of 50 mm/minute to measure the peeling strength. The peel width was 10 mm ± 0.1 mm. The peeling strength was measured by using TENSILON UMT-4-100 manufactured by Toyo Baldwin Ltd.

In Fig. 8(A), a bar graph on the left side represents the tensile strength of the composite material (comparative example) obtained by bonding copper foil not provided with laser processing to a resin material, and a bar graph on the right side represents the tensile strength of the composite material (example) obtained by bonding copper foil provided with laser processing to a resin material. As understood from Fig. 8(A), the tensile strength was improved by 16% approximately by performing laser processing on the copper foil.

In a second peeling experiment, two kinds of composite materials each produced by bonding the S surface of copper foil to a resin substrate made of FR4 R-1766, which is manufactured by Panasonic Corporation, with or without laser processing were prepared. The copper foil was joined to R-1766, which is manufactured by Panasonic Corporation, at a curing temperature of 170°C for a curing time of one hour.

Then, the tensile strength (peel strength) when these prepared composite materials were each cut and peeled off was measured. Specifically, the resin side of each produced measurement sample was fixed by a support clasp, and the copper foil was peeled off in the direction at 90° to the measurement sample at the speed of 50 mm/minute to measure the peeling strength. The peel width was 10 mm ± 0.1 mm. The peeling strength was measured by using TENSILON UMT-4-100 manufactured by Toyo Baldwin Ltd.

In Fig. 8(B), a bar graph on the left side represents the tensile strength of the composite material (comparative example) obtained by bonding copper foil not provided with laser processing to a resin material, and a bar graph on the right side represents the tensile strength of the composite material (example) obtained by bonding copper foil provided with laser processing to a resin material. As understood from Fig. 8(B), the tensile strength was improved by 86% approximately by performing laser processing on the copper foil.

In a third peeling experiment, two kinds of composite materials each produced by bonding the S surface of copper foil to a resin substrate made of MEGTRON6 R-5670 with or without laser processing were prepared. The copper foil was joined to MEGTRON6 R-5670 at a curing temperature of 200°C for a curing time of two hours.

Then, the tensile strength (peel strength) when these prepared composite materials were each cut and peeled off was measured. Specifically, the resin side of each produced measurement sample was fixed by a support clasp, and the copper foil was peeled off in the direction at 90° to the measurement sample at the speed of 50 mm/minute to measure the peeling strength. The peel width was 10 mm ± 0.1 mm. The peeling strength was measured by using TENSILON UMT-4-100 manufactured by Toyo Baldwin Ltd.

In Fig. 8(C), a bar graph on the left side represents the tensile strength of the composite material (comparative example) obtained by bonding copper foil not provided with laser processing to a resin material, and a bar graph on the right side represents the tensile strength of the composite material (example) obtained by bonding copper foil provided with laser processing to a resin material. As understood from Fig. 8(C), the tensile strength was improved by 128% approximately by performing laser processing on the copper foil.

As understood from the measurement results of the tensile strength illustrated in Fig. 8 described above, when laser processing is performed on copper foil to form a periodic structure and a coating, the periodic structure and the coating function as an anchor when joined with a resin material, thereby improving adhesion with the resin material.

As described above with reference to Figs. 6 to 8, when a periodic structure on the order of the laser wavelength is formed on the copper surface 11 of the copper foil 10, a high-frequency signal can be transmitted at low loss, and the periodic structure functions as an anchor when joined with another member to have favorable adhesion with the member.

The laser processing method according to the present embodiment is not limited the example described above but is applicable to, for example, a method of manufacturing a multi-layer printed circuit board as described below. Specifically, in the process of stacking press of a multi-layer printed circuit board, the upper surface of an inner-layer wire formed by etching is adhered to resin stacked above. Thus, the upper surface of the wire is required to be roughed. The laser processing according to the present embodiment described above has high position selectivity, and thus is preferable for roughing of the upper surface of a wire in such a multi-layer board manufacturing process. For this reason, it is preferable to form a periodic structure on the order of the laser wavelength at an inner-layer wiring part of the multi-layer printed circuit board by selectively irradiating the inner-layer wiring part with pulse laser having a laser power close to a threshold beyond which copper processing is possible and having a pulse width on the order of nanoseconds. In particular, for example, the processing beam diameter can be reduced up to 10 µm, and thus a fine wire having a width of 10 µm can be selectively roughed.

In addition, the direction of a periodic structure can be changed in accordance with a wire by controlling polarization. Specifically, a periodic structure having a period of 0.35 µm to 2 µm in a planar direction and a height of less than 1.5 µm can be formed parallel to a current conduction direction by controlling polarization. Thus, a fine periodic structure can be formed parallel to the direction of current flow by changing the direction of the periodic structure in this manner. Then, when such a fine periodic structure is formed parallel to the direction of current flow, it is possible to increase adhesion to resin while reducing degradation of a transmission loss as compared to a case in which the fine periodic structure is formed, for example, orthogonal to the direction of current flow.

In the above-described embodiment, a dendrite structure is exemplarily described as an irregular structure formed on the coating 13, but the irregular structure may be another structure other than a dendrite structure as long as the surface area of the coating 13 is larger than the surface area of the copper surface 11.

### List of Reference Signs

- 10: copper foil
- 11: copper surface
- 12: periodic structure
- 13: coating
- 2: pulse laser
- 450A: dendrite structure

## Claims

1. A laser processing method of performing surface processing on a copper surface by using laser,
the method being **characterized by** forming a periodic structure on an order of laser wavelength on the copper surface by irradiating the copper surface with pulse laser having a laser power close to a threshold beyond which copper processing is possible and having a pulse width on an order of nanoseconds.

2. The laser processing method according to claim 1, **characterized by** forming a coating on the copper surface together with forming the periodic structure on the order of laser wavelength on the copper surface.

3. The laser processing method according to claim 1 or 2, **characterized by** forming a dendrite structure having a period shorter than a period of the periodic structure on the order of laser wavelength by accumulating or depositing copper at a protruding part of the periodic structure on the order of laser wavelength.

4. The laser processing method according to any one of claims 1 to 3, **characterized in that** the periodic structure on the order of laser wavelength is formed by:
referring to a laser processing condition of a first pulse width and a first fluence with which formation of a groove in a size equivalent to a processing beam diameter on the copper surface is possible, and a laser processing condition of a second pulse width and a second fluence that have values smaller than values of the first pulse width and the first fluence, respectively, and with which removal of only a copper compound coating from the copper surface is possible, and
irradiating the copper surface with pulse laser having a pulse width set to be between the first pulse width and the second pulse width and a fluence set to be between the first fluence and the second fluence.

5. The laser processing method according to any one of claims 1 to 4, **characterized in that** the copper surface is irradiated with pulse laser having a wavelength of 1000 nm to 1600 nm, a pulse width of 0.8 ns to 5.0 ns, and a fluence of 1.0×10⁸ W/cm² to 4.0×10⁹ W/cm² under air or atmosphere of oxygen, water, or active gas.

6. The laser processing method according to any one of claims 1 to 5, **characterized in that** the copper surface is repeatedly irradiated with pulse laser having at least one of parameters of frequency, laser intensity, scanning speed, spot size, wavelength, and atmosphere adjusted in accordance with a height and shape of a periodic structure to be formed on the copper surface.

7. The laser processing method according to any one of claims 1 to 6, **characterized in that** the periodic structure is formed in a predetermined direction on the copper surface by irradiating the copper surface with the pulse laser while controlling a polarization direction of the pulse laser.

8. The laser processing method according to any one of claims 1 to 7, **characterized in that** the copper surface is irradiated with the pulse laser having an energy profile set in a top hat shape.

9. The laser processing method according to any one of claims 1 to 8, **characterized in that** an identical irradiation position on the copper surface is irradiated with the pulse laser while the fluence of the pulse laser is gradually reduced.

10. A joint method of joining copper foil to a resin material, the method being **characterized by** comprising:
forming a roughed part having a periodic structure on an order of laser wavelength on a surface of the copper foil by irradiating the surface of the copper foil with pulse laser having a laser power close to a threshold beyond which copper processing is possible and having a pulse width on an order of nanoseconds; and
performing laser welding or heat press bonding of the roughed part formed on the surface of the copper foil to the resin material.

11. A copper member **characterized in that**, on at least one surface of the copper member, a periodic structure having a period of 0.35 µm to 2 µm in a planar direction and a height of less than 1.5 µm is formed.

12. The copper member according to claim 11, **characterized in that** the ratio of the height of the periodic structure relative to a thickness of the copper member is 0.15% to 30% inclusive.

13. The copper member according to claim 11 or 12, **characterized in that**
a coating is formed on the periodic structure, and
an irregular structure having a period shorter than a period of the periodic structure is formed on a surface of the coating.

14. The copper member according to claim 13, **characterized in that** a surface area of the coating on which the irregular structure is formed is at least ten times larger than a surface area of the surface on which the periodic structure is formed.

15. The copper member according to claim 13 or 14, **characterized in that** the irregular structure is made of a dendrite structure.

16. The copper member according to claim 12 or 13, **characterized in that** the copper member is copper foil.

17. A printed circuit board manufacturing method of manufacturing a multi-layer printed circuit board, the method being **characterized by** forming a periodic structure on an order of laser wavelength at an inner-layer wiring part of the multi-layer printed circuit board by selectively irradiating the inner-layer wiring part with pulse laser having a laser power close to a threshold beyond which copper processing is possible and having a pulse width on an order of nanoseconds.

18. A multi-layer printed circuit board on which an inner-layer wiring part is formed, **characterized in that** a periodic structure having a period of 0.35 µm to 2 µm in a planar direction and a height of less than 1.5 µm is formed in parallel to a current conduction direction at the inner-layer wiring part.
